# EUROPEAN PATENT APPLICATION

(11) **EP 4 161 228 A1**
(43) Date of publication of application: **05.04.2023**
(21) Application number: 21865694.0
(22) Date of filing: 20.07.2021
(51) Int. Cl.: H05K 5/02, G02F 1/1514

(54) **COVER PLATE ASSEMBLY AND ELECTRONIC DEVICE**

(30) Priority: 11.09.2020 CN 202010955536
(71) Applicant: GUANGDONG OPPO MOBILE TELECOMMUNICATIONS CORP., LTD., Dongguan, Guangdong 523860 (CN)
(72) Inventor: WANG, Lei, Dongguan, Guangdong 523860 (CN)
(74) Representative: Manitz Finsterwald Patent- und Rechtsanwaltspartnerschaft mbB
(86) International application number: PCT/CN2021/107463
(87) International publication number: WO 2022/052638

(57) **Abstract**

The present application provides a cover plate assembly and an electronic device, relating to the technical field of electronic devices having a color-changing function. In the present application, an electrochromic module and a transparent cover plate are arranged in a stacked manner, the electrochromic module comprises an encapsulation portion, a color-changing portion, and metal wiring, the encapsulation portion is used for encapsulating the peripheral side of the color-changing potion, and the metal wiring is arranged in the encapsulation portion or in the color-changing portion at a position close to the encapsulation portion; and a shielding layer is located between the transparent cover plate and the electrochromic module, and the encapsulation portion and the metal wiring are located in the orthographic projection area of the shielding layer on the electrochromic module. In the present application, the shielding layer is used for shielding the encapsulation portion and the metal wiring, so that structures such as the metal wiring and the encapsulation portion are not displayed on a cover plate assembly, and the appearance of a cover plate assembly is better exhibited.

## Description

### TECHNICAL FIELD

The present disclosure relates to the technical field of an electronic device with color changing function, and in particular to a cover plate assembly and an electronic device.

### BACKGROUND

For a decoration example of a built-in decorative film or a film directly coated on a transparent cover plate, a color or pattern of an outer shell may be very beautiful, but the color and the pattern cannot be changed. Even though some special texture effects show different colors at different angles, the color and the pattern presented by the outer shell are still not rich.

### SUMMARY

According to an aspect of the present disclosure, a cover plate assembly is provided. The cover plate assembly includes:
a transparent cover plate;
an electrochromic module, stacked on the transparent cover plate; wherein the electrochromic module includes an encapsulation portion, a color-changing portion and a metal wire, the encapsulation portion encapsulates a peripheral side of the color-changing portion, and the metal wire is arranged in the encapsulation portion or arranged in the color-changing portion close to the encapsulation portion; and
a shielding layer, disposed between the transparent cover plate and the electrochromic module; wherein the encapsulation portion and the metal wire are located within an orthographic projection region of the shielding layer on the electrochromic module.

According to another aspect of the present disclosure, an electronic device is provided. The electronic device includes a display module, a middle frame, a main board, and the above-mentioned cover plate assembly. The display module and the cover plate assembly are respectively disposed on opposite sides of the middle frame and are fixedly connected with the middle frame. The electrochromic module is closer to the display module than the transparent cover plate. The main board is coupled with the electrochromic module, and the main board is configured to receive a control command to control the electrochromic module to change color.

In the present disclosure, the shielding layer is used to shield the encapsulation portion and the metal wire, such that the metal wire, the encapsulation portion, and other structures cannot be displayed on the cover plate assembly. Thus, the appearance expression of the cover plate assembly is enhanced.

### BRIEF DESCRIPTION OF THE DRAWINGS

To illustrate the technical solutions more clearly in the embodiments of the present disclosure, the following will be briefly described in the description of the embodiments required to use the attached drawings. It is obvious that the following description of the attached drawings only show some of the embodiments of the present disclosure, and those skilled in the art, without creative work, can also obtain other attached drawings based on these drawings.
FIG. 1 illustrates a top view of an electrochromic module according to an embodiment of the present disclosure.
FIG. 2 illustrates a schematic cross-sectional view of the electrochromic module along I-I shown in FIG. 1 according to an embodiment of the present disclosure.
FIG. 3 illustrates a schematic view of a circuit connection between a first conductive layer, a second conductive layer and a flexible circuit board shown in FIG. 1 according to an embodiment of the present disclosure.
FIG. 4 illustrates a schematic cross-sectional view of the electrochromic module along I-I shown in FIG. 1 according to another embodiment of the present disclosure.
FIG. 5 illustrates a schematic cross-sectional view of the circuit connection between the first conductive layer, the second conductive layer and the flexible circuit board according to another embodiment of the present disclosure.
FIG. 6 illustrates a schematic cross-sectional view of the electrochromic module along I-I shown in FIG. 1 according to another embodiment of the present disclosure.
FIG. 7 illustrates a schematic view of a circuit connection between a first conductive layer, a second conductive layer and a flexible circuit board shown in FIG. 1 according to another embodiment of the present disclosure.
FIG. 8 illustrates a schematic cross-sectional view of the electrochromic module along I-I shown in FIG. 1 according to another embodiment of the present disclosure.
FIG. 9 illustrates a schematic cross-sectional view of the electrochromic module along I-I shown in FIG. 1 according to another embodiment of the present disclosure.
FIG. 10 illustrates a schematic cross-sectional view of the electrochromic module along I-I shown in FIG. 1 according to another embodiment of the present disclosure.
FIG. 11, FIG. 12, FIG. 13, and FIG. 14 respectively illustrate schematic cross-sectional views of the electrochromic module along I-I shown in FIG. 1 according to some embodiments of the present disclosure.
FIG. 15 and FIG. 16 respectively illustrate schematic cross-sectional views of the electrochromic module along I-I shown in FIG. 1 according to some embodiments of the present disclosure.
FIG. 17 illustrates a top view of a cover plate assembly according to an embodiment of the present disclosure.
FIG. 18 illustrates a schematic cross-sectional view of the cover plate assembly along II-II shown in FIG. 17 according to an embodiment of the present disclosure.
FIG. 19, FIG. 20 and FIG. 21 respectively illustrate structural schematic views of a cover plate according to different embodiments of the present disclosure.
FIG. 22 illustrates a top view of the cover plate assembly according to another embodiment of the present disclosure.
FIG. 23 illustrates a top view of the cover plate assembly according to another embodiment of the present disclosure.
FIG. 24 illustrates a schematic cross-sectional view of the cover plate assembly along III-III shown in FIG. 22 according to an embodiment of the present disclosure.
FIG. 25 illustrates a schematic cross-sectional view of the cover plate assembly along III-III shown in FIG. 22 according to another embodiment of the present disclosure.
FIG. 26 illustrates a schematic cross-sectional view of the cover plate assembly along III-III shown in FIG. 22 according to another embodiment of the present disclosure.
FIG. 27 illustrates a schematic cross-sectional view of the cover plate assembly along III-III shown in FIG. 22 according to another embodiment of the present disclosure.
FIG. 28 illustrates a block diagram of a structure of an electronic device according to an embodiment of the present disclosure.
FIG. 29 illustrates a block diagram of a structure of the electronic device according to another embodiment of the present disclosure.
FIG. 30 illustrates a structural schematic view of the electronic device according to an embodiment of the present disclosure.
FIG. 31 and FIG. 32 respectively illustrate schematic views of operation states of the electronic device according to some embodiments of the present disclosure.
FIG. 33 illustrates a structural schematic view of the electronic device according to another embodiment of the present disclosure.

### DETAILED DESCRIPTION

The present application is further described in detail below in combination with the drawings and embodiments. In particular, the following embodiments are only used to describe the present disclosure, but do not limit the scope of the present disclosure. Similarly, the following embodiments are only part of the present disclosure rather than all of the embodiments. All other embodiments obtained by ordinary technicians in the art without creative work belong to the protection scope of the present disclosure.

Mentioning "embodiments" herein means that a specific features, structure or characteristic described in combination with the embodiments may be included in at least one embodiment of the present disclosure. The phrase appearing in various positions in the specification does not necessarily refer to the same embodiment, nor is it an independent or alternative embodiment mutually exclusive with other embodiments. Those skilled in the art explicitly and implicitly understand that the embodiments described herein can be combined with other embodiments.

The "electronic device" (also referred to as "terminal", "mobile terminal", or "electronic device") used herein includes, but is not limited to, being set to connect via wired lines connections(such as via Public Switched Telephone Networks (PSTN), Digital Subscriber Line (DSL), digital cable, direct cable connection, and/or another data connection/network), and/or a device that receives/transmits a communication signal via a wireless interface (for example, for a cellular network, a wireless local area network (WLAN), a digital television network such as a DVB-H network, a satellite network, an AM-FM broadcast transmitter, and/or another communication terminal). The communication terminal set to communicate through the wireless interface may be called "wireless communication terminal", "wireless terminal", or "mobile terminal". Examples of the mobile terminal include, but are not limited to, satellite or cellular phones, Personal communications system (PCS) terminals that may combine cellular radiotelephones with data processing, facsimile, and data communication capabilities, PDAs that may include radiophones, pagers, Internet/intranet access, Web browsers, notepads, calendars, and/or global positioning system (GPS) receivers, and conventional laptop and/or handheld receivers or other electronic devices including radiotelephone transceivers. The mobile phone is an electronic device equipped with a cellular communication module.

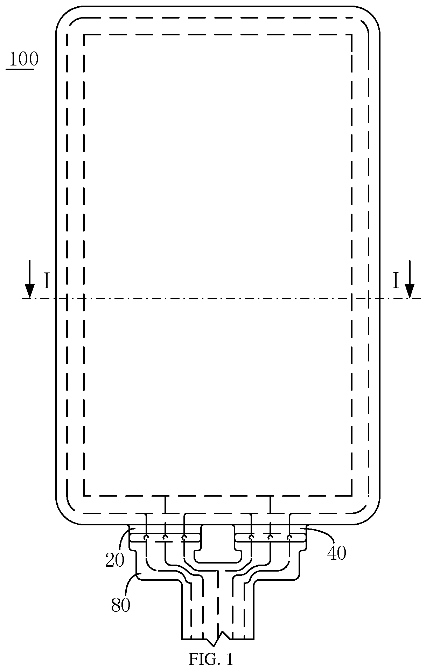

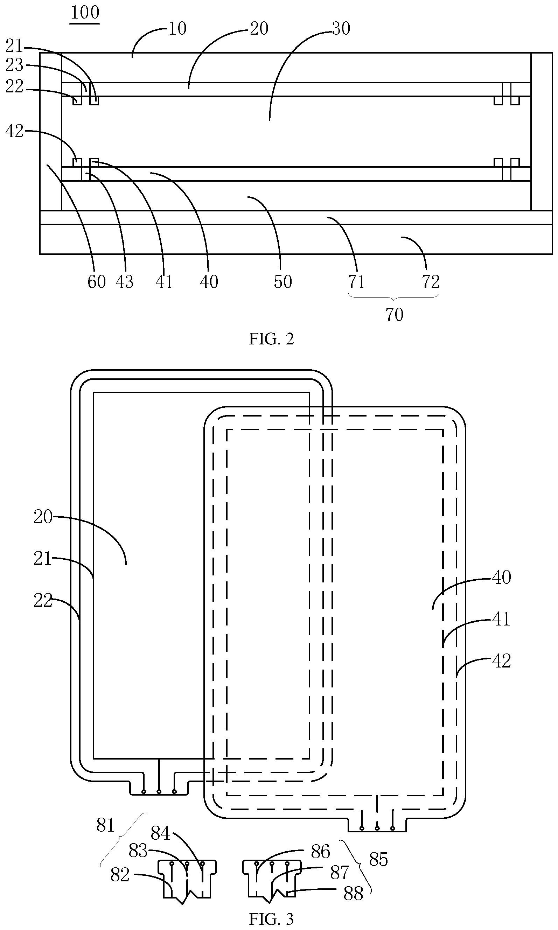

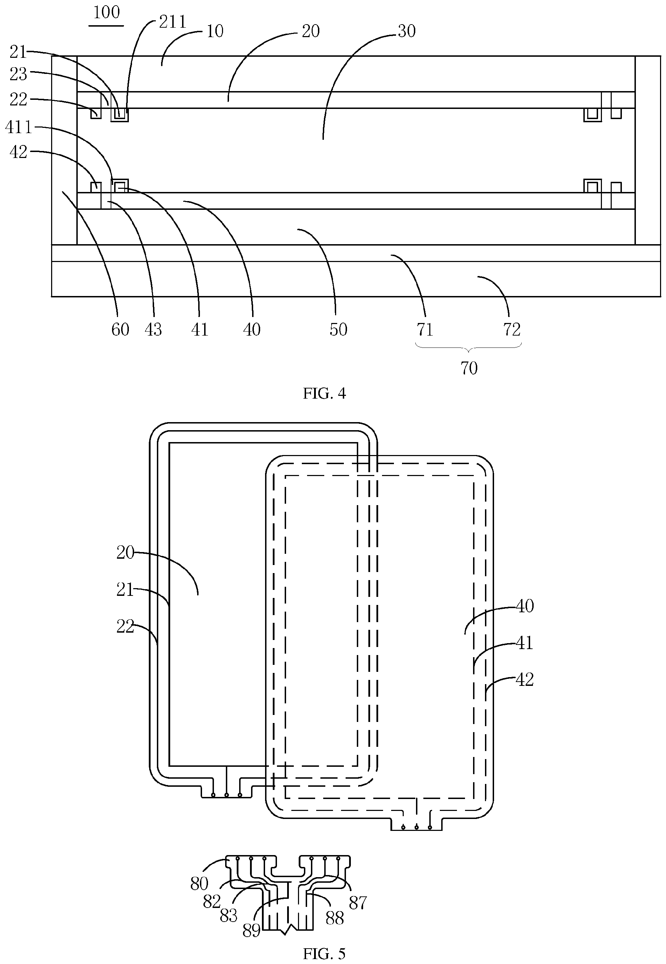

As shown in FIGS. 1-4, FIG. 1 illustrates a top view of an electrochromic module (also known as an electrochromic device) according to an embodiment of the present disclosure, FIG. 2 illustrates a schematic cross-sectional view of the electrochromic module along I-I shown in FIG. 1 according to an embodiment of the present disclosure, FIG. 3 illustrates a schematic view of a circuit connection between a first conductive layer, a second conductive layer and a flexible circuit board (FPC) shown in FIG. 1 according to an embodiment of the present disclosure, and FIG. 4 illustrates a schematic cross-sectional view of the electrochromic module along I-I shown in FIG. 1 according to another embodiment of the present disclosure. The electrochromic module 100 may include a first substrate 10, a first conductive layer 20, a color-changing material layer 30, a second conductive layer 40, a second substrate 50, an adhesive frame 60, a water and oxygen blocking unit 70, and a flexible circuit board 80. The first substrate 10, the first conductive layer 20, the color-changing material layer 30, the second conductive layer 40, the second substrate 50, and the water and oxygen blocking unit 70 are successively stacked. The adhesive frame 60 is disposed around a peripheral side of the color-changing material layer 30. The adhesive frame 60, the first conductive layer 20, and the second conductive layer 40 cooperatively define a chamber, and the chamber is configured to fill a color-changing material to form the color-changing material layer 30. The first substrate 10 is configured to support and carry the first conductive layer 20. The second substrate 50 is configured to support and carry the second conductive layer 40. The first substrate 10 and the second substrate 50 make the electrochromic module 100 form a complete product, such that the electrochromic module 100 may be used normally. The adhesive frame 60 and/or the water and oxygen blocking unit 70 are configured to completely isolate the electrochromic module 100, such as the color-changing material layer 30, from external water oxygen environment, thereby reducing oxidation failure of the color-changing material. The flexible circuit board 80 is configured to electrically connect with the first conductive layer 20 and the second conductive layer 40 respectively, so as to realize energizing the first conductive layer 20 and the second conductive layer 40, thereby driving the color-changing material layer 30 between the first conductive layer 20 and the second conductive layer 40 to change color (coloring or discoloring).

It should be noted that, the terms "first", "second", etc., herein and below are intended for descriptive purposes only and are not to be construed as indicating or implying relative importance or implicitly specifying the number of indicated technical features. Therefore, the features defined as "first" and "second" may explicitly or implicitly include one or more of the features.

It can be understood that the terms of "the first conductive layer" and "the second conductive layer" may be converted to each other in different embodiments. In an embodiment, for example, "the first conductive layer" may also be called as "the second conductive layer".

As shown in FIG. 2, the first substrate 10 is adhered to the first conductive layer 20, so as to support the first conductive layer 20. Material of the first substrate 10 may be a glass or a transparent resin with certain hardness, such as polyethylene terephthalate (PET or PEIT, commonly known as polyester resin, namely, condensation polymer of terephthalic acid and ethylene glycol), polymethyl methacrylate ((PMMA), also known as Acrylic or organic glass), polycarbonate (PC), polyimide (PI), cyclic cycloolefin copolymer, etc. More material types of the first substrate 10 should be within understanding scope of those skilled in the art, which is not be listed and detailed herein.

As shown in FIG. 2 and FIG. 3, the first conductive layer 20 is disposed between the first substrate 10 and the color-changing material layer 30. The first conductive layer 20 is adhered to the first substrate 10 and the color-changing material layer 30 respectively. The first conductive layer 20 is made of a transparent conductive material. The transparent conductive material may be indium tin oxide (ITO), zinc aluminum oxide (AZO), graphene film, or the like.

A first metal wire 21 and a first ground wire 22 are arranged on a side of the first conductive layer 20 facing towards the color-changing material layer 30. The first metal wire 21 is configured to be electrically connected with the first conductive layer 20, so as to energize the first conductive layer 20, and thus it is possible to configure to drive the color-changing material layer 30 to change color (coloring or discoloring). The first metal wire 21 and the first ground wire 22 are arranged at intervals, so as to prevent short circuiting between the first metal wire 21 and the first ground wire 22. The first ground wire 22 is configured to provide electrostatic protection of the electrochromic module 100. In an embodiment, the first ground wire 22 may be omitted.

In an embodiment, the first metal wire 21 is configured to be electrically connected with the flexible circuit board 80, so as to supply power to the electrochromic module 100. The first metal wire 21 may adopt closed loop wiring. In an embodiment, as shown in FIG. 2, the first metal wire 21 is arranged close to the adhesive frame 60. A wiring range of the first metal wire 21 may be as large as possible around the color-changing material layer 30. A material impedance of the first metal wire 21 may be selected within 5Q. Of course, the smaller the material impedance, the better. The first metal wire 21 may be formed by arranging a metal film and then etching, or by using a partial metal coating, that is, a metal coating is performed at a position where the wiring is required. Material of the first metal wire 21 may be a metal material with good conductivity, such as molybdenum, aluminum, silver, gold, copper, or the like. In an embodiment, the first metal wire 21 may be a metal conductor formed on the first conductive layer 20 by means of screen printing, and a resistance of the first metal wire 21 is extremely low, for example, 1.6×10⁻⁶Ω·cm. In an embodiment, the first metal wire 21 may be a silver paste wire formed on an edge of the first conductive layer 20 via a silver paste wire device. Therefore, the first metal wire 21 may also be called as the silver paste wire.

In an embodiment, the first ground wire 22 is disposed around a periphery of the first metal wire 21, so as to provide electrostatic protection of the first metal wire 21, thereby protecting the flexible circuit board 80 and the electronic device which are connected with the first metal wire 21. The first ground wire 22 may be made of the same material as the first metal wire 21, or may be designed in the same way as the first metal wire 21. For the material and arrangement ways of the first ground wire 22, it is possible to make design with reference to the material and arrangement method of the first metal wire 21. In an embodiment, as shown in FIG. 2, the first ground wire 22 is arranged close to the adhesive frame 60.

In an embodiment, in order to prevent short circuiting between the first metal wire 21 and the first ground wire 22, a first isolation groove 23 is defined on the first conductive layer 20 between the first metal wire 21 and the first ground wire 22. The first isolation groove 23 penetrates the first conductive layer 20, such that the first conductive layer 20 is divided into two parts that are not connected with each other, thereby insulating the first metal wire 21 from the first ground wire 22. In this way, it is possible to prevent the short circuiting between the first metal wire 21 and the first ground wire 22. In an embodiment, the first isolation groove 23 may be filled with insulating glue to achieve integrity of the first conductive layer 20. In an embodiment, the first isolation groove 23 may be omitted, and an insulating layer is arranged between the first ground wire 22 and the first conductive layer 20, so as to prevent the first ground wire 22 from being electrically connected to the first conductive layer 20, thereby preventing the short circuiting between the first metal wire 21 and the first ground wire 22. In an embodiment, as shown in FIG. 4, an insulation protection layer 211 may be arranged on a surface where the first metal wire 21 contacts the color-changing material layer 30, so as to block the first metal wire 21 from directly contacting the color-changing material layer 30, thereby preventing the short circuiting between the first metal wire 21 and the first ground wire 22.

As shown in FIG. 2 and FIG. 4, the color-changing material layer 30 is adhered to the first conductive layer 20 and the second conductive layer 40 respectively, thereby achieving to change color (coloring or discoloring) when a voltage is applied. An electrochromic material of the color-changing material layer 30 may be organic polymers (such as polyaniline, polythiophene, etc.), inorganic materials (Prussian blue, transition metal oxides, such as tungsten trioxide), and small organic molecules (viologen), etc. When the color-changing material layer 30 is the organic polymer or the inorganic material, the color-changing material layer 30 has a similar structure. In an embodiment, a color-changing material of the color-changing material layer 30 may be a solid or gelled material.

As shown in FIGS. 2-4, the second conductive layer 40 is similar to the first conductive layer 20. The second conductive layer 40 is provided with a second metal wire 41, a second ground wire 42, and a second isolation groove 43. The second conductive layer 40 has the same function as the first conductive layer 20, and a structure and material of the second conductive layer 40 are substantially similar to those of the first conductive layer 20 as shown in FIGS. 2-4. The second conductive layer 40, the second metal wire 41, the second ground wire 42, and the second isolation groove 43 will not be described for details, and only main components may be listed. For mating relationships and functions, it is possible to make design with reference to introduction of the first conductive layer 20. In an embodiment, at most one of the first ground wire 22 and the second ground wire 42 may be omitted. In an embodiment, the second isolation groove 43 may be filled with the insulating glue. In an embodiment, the first ground wire 22 and the second ground wire 42 are arranged opposite to each other or arranged in a staggered manner. In an embodiment, the first isolation groove 23 are arranged opposite to each other or arranged in a staggered manner. In an embodiment, the first metal wire 21 and the second metal wire 41 are arranged opposite to each other or arranged in a staggered manner. In an embodiment, the second isolation groove 43 may be omitted, and an insulating layer is arranged between the second ground wire 42 and the second conductive layer 40, so as to prevent the second ground wire 42 from being electrically connected to the second conductive layer 40, thereby preventing short circuiting between the second metal wire 41 and the second ground wire 42. In an embodiment, as shown in FIG. 4, an insulation protection layer 411 is arranged on a surface of the second metal wire 41 in contact with the color-changing material layer 30, so as to block the second metal wire 11 from directly contacting with the color-changing material layer 30, so as to prevent the short circuiting between the second metal wire 41 and the second ground wire 42. In an embodiment, as shown in FIG. 2, the second metal wire 41 and the second ground wire 42 are close to the adhesive frame 60.

It can be understood that, the names "first metal wire", "second metal wire", and "metal wire", etc., may be converted to each other in different embodiments. In an embodiment, for example, "first metal wire" may also be called "second metal wire" or "metal wire".

It can be understood that, the names of "first ground wire", "second ground wire", and "ground wire", etc., may be converted to each other in different embodiments. In an embodiment, for example, "first ground wire" may also be called "second ground wire" or "ground wire".

As shown in FIGS. 2-4, the first conductive layer 20, the color-changing material layer 30, and the second conductive layer 40 may be disposed or prepared by a physical vapor deposition (PVD) method. The PVD method may specifically include vacuum evaporation, sputtering, ion plating (hollow cathode ion plating, hot cathode ion plating, arc ion plating, active reaction ion plating, radio frequency ion plating, direct-current discharge ion plating), and the like.

As shown in FIG. 2 and FIG. 4, the second substrate 50 is similar to the first substrate 10, and the function, structure, and material of the second substrate 50 are substantially similar to those of the first substrate 10. The specific mating relationship and function of the second substrate 50 may be found in the relevant description of the first substrate 10, which will not be repeated herein. In an embodiment, the second substrate 50 may be replaced by a process protective layer, and the process protective layer may be directly arranged on the second conductive layer 40. The process protective layer may be a single layer or a multi-layer structure disposed or prepared by the physical vapor deposition method. Material of the process protective layer may be a dense metal oxide or an inorganic non-metal, such as silicon oxide, aluminum oxide, titanium oxide, etc. By arranging the process protection layer on the second conductive layer 40, during a process of manufacturing the electrochromic module 100, water vapor may be prevented from penetrating into an interior of the electrochromic module 100 (especially the color-changing material layer 30), and it is further possible to prevent ions in other layers from penetrating into the interior of the electrochromic module 100, thereby forming barrier protection for the electrochromic module 100. Therefore, it is possible to prevent ion penetration from damaging the color-changing material layer 30, thereby improving the reliability of the electrochromic module 100. It can be understood that the first substrate 10 may also be replaced by the process protective layer.

As shown in FIG. 2 and FIG. 4, the adhesive frame 60 may be disposed around the peripheral side of the first substrate 10, the first conductive layer 20, the color-changing material layer 30, the second conductive layer 40, and the second substrate 50. Further, the adhesive frame 60 may be adhered to the first substrate 10, the first conductive layer 20, the color-changing material layer 30, the second conductive layer 40, and the second substrate 50, respectively. The adhesive frame 60 is configured to adhere the first conductive layer 20 to the second conductive layer 40, such that a chamber is defined between the first conductive layer 20 and the second conductive layer 40. The chamber is configured to fill the color-changing material to form the color-changing material layer 30. In addition, the adhesive frame 60 may also prevent the water vapor from penetrating from a side of the electrochromic module 100 into the interior of the electrochromic module 100, such as the color-changing material layer 30. In an embodiment, the performance requirements of a glue applied to the adhesive frame 60 are as follows: A. content of Na⁺ and K⁺ in the glue material is low; B. adhesive force between the glue and a glass surface, the water and oxygen blocking unit 70, and a PET surface is high; C. viscosity is in a range from 30000mPa*s to 150000mPa*s; D. water vapor transmittance (WVTR) value is less than 1×10⁻²g/m²/day; E. curing conditions mainly include ultraviolet light (UV) curing, and UV & heat curing in low temperature ( < 90°C), and the glue has a certain flexibility after the glue is cured. In an embodiment, the adhesive frame 60 may be formed of a UV curing adhesive. Material of the adhesive frame 60 are usually mixed with a UV curing frame adhesive and a heat curing frame adhesive according to certain components to make a UV heating curing mixed frame adhesive.

As shown in FIG. 2 and FIG. 4, the color-changing material layer 30 (including the mixture of an electrochromic functional material, an electrolyte, and an ion storage layer) of the electrochromic module 100 undergoes redox reaction under a certain voltage, which is manifested as coloring and discoloring changes. The change process may experience some unstable chemical states. The change process is sensitive to water and oxygen, that is, a small amount of the water and oxygen mixed into the color-changing material layer 30 may cause irreversible side reactions, resulting in failure of the electrochromic module 100. Therefore, the water and oxygen barrier unit 70 is adhered on the second substrate 50 and an end portion of the adhesive frame 60 away from a side of the first substrate 10, so as to well encapsulate the electrochromic module 100, thereby strictly isolating the color-changing material layer 30 from the water and oxygen. The water and oxygen blocking unit 70 is configured to completely isolate the electrochromic module 100 from the external water oxygen environment. The water and oxygen blocking unit 70 may include a water and oxygen blocking layer 71 and a third substrate 72. The water and oxygen blocking layer 71 is plated on the third substrate 72. Material of the third substrate 72 may be similar to that of the first substrate 10. Specifically, the material of the third substrate 72 may be found in the relevant description of the first substrate 10, which will not be repeated herein. In an embodiment, the water and oxygen blocking layer 71 may be a dense inorganic layer (SiO₂ or Al₂O₃), an organic layer, or an organic-inorganic superimposed composite layer, and the water and oxygen blocking layer 71 may be plated on the third substrate 72 via a flash evaporation process, or an atomic layer deposition coating (ALD) process. In an embodiment, the water and oxygen blocking layer 71 is disposed between the second substrate 50 and the third substrate 72. In an embodiment, the water and oxygen blocking unit 70 may be omitted. In an embodiment, the third substrate 72 may be omitted, and the water and oxygen blocking layer 71 may be directly arranged on the second substrate 50.

In an embodiment, the second substrate 50 may be adhered to the water and oxygen blocking unit 70 via a transparent optical adhesive (OCA). That is, an OCA optical adhesive layer may be arranged between the second substrate 50 and the water and oxygen blocking unit 70.

As shown in FIG. 3, the first conductive layer 20 is provided with the first metal wire 21 and the first ground wire 22, and the second conductive layer 40 is provided with the second metal wire 41 and the second ground wire 42. The first metal wire 21, the first ground wire 22, the second metal wire 41, and the second ground wire 42 are electrically connected with the flexible circuit board 80, respectively, such that the electrochromic module 100 is electrically connected to the electronic device via the flexible circuit board 80.

In an embodiment, as shown in FIG. 1 and FIG. 3, the flexible circuit board 80 is provided with a first circuit wire 81 and a second circuit wire 85. The first metal wire 21 and the first ground wire 22 of the first conductive layer 20 are electrically connected with the first circuit wire 81, respectively. The second metal wire 41 and the second ground wire 42 of the second conductive layer 40 are electrically connected with the second circuit wire 85, respectively.

The first circuit wire 81 of the flexible circuit board 80 includes a first ground wire 82, a control wire 83, and a second ground wire 84, which are sequentially arranged side by side. The first ground wire 82 is electrically connected with one end of the first ground wire 22, and the second ground wire 84 is electrically connected with the other end of the first ground wire 22. The control wire 83 is electrically connected with the first metal wire 21.

The second circuit wire 85 of the flexible circuit board 80 includes a first ground wire 86, a control wire 87, and a second ground wire 88, which are sequentially arranged side by side. The first ground wire 86 is electrically connected with one end of the second ground wire 42, and the second ground wire 88 is electrically connected with the other end of the second ground wire 42. The control wire 87 is electrically connected with the second metal wire 41.

In an embodiment, as shown in FIG. 5, FIG. 5 illustrates a schematic cross-sectional view of the circuit connection between the first conductive layer, the second conductive layer and the flexible circuit board (FPC) according to another embodiment of the present disclosure. Connection relationships between the first conductive layer 20, the second conductive layer 40, and the flexible circuit board 80 shown in FIG. 5 are similar to those shown in FIG. 3. As shown in FIG. 5, compared with the connection relationships shown in FIG. 3, the second ground wire 84 shown in FIG. 5 is short-circuited with the first ground wire 86 to form a third ground wire 89. As shown in FIG. 5, the flexible circuit board 80 is provided with the first ground wire 82, the control wire 83, the third ground wire 89, the control wire 87 and the second ground wire 88, which are sequentially arranged side by side. In an embodiment, as shown in FIG. 5, the first ground wire 82 is electrically connected with the one end of the first ground wire 22. The third ground wire 89 is electrically connected with the other end of the first ground wire 22, and the third ground wire 89 is electrically connected with one end of the second ground wire 42. The second ground wire 88 is electrically connected with the other end of the second ground wire 42. The control wire 83 is electrically connected with the first metal wire 21, and the control wire 87 is electrically connected with the second metal wire 41.

It can be understood that, the names of "first circuit wire", "second circuit wire", and "circuit wire" may be converted to each other in different embodiments. In an embodiment, for example, "first circuit wire" may also be referred to as "second circuit wire" or "circuit wire".

It can be understood that, the names of "first ground wire", "second ground wire", "third ground wire", and "ground wire" may be converted to each other in different embodiments. In an embodiment, for example, "first ground wire" may also be called as "second ground wire" or "ground wire".

In an embodiment, the first substrate 10 is further provided with a wiring connection end, and the wiring connection end is adjacent to and insulated from the first metal wire 21 and/or the first ground wire 22. The second metal wire 41 and/or the second ground wire 42 are electrically connected with the wiring connection end of the first substrate 10. The flexible circuit board 80 is electrically connected with the wiring connection end, and the first metal wire 21 and/or the first ground wire 22, respectively. In an embodiment, the second metal wire 41 may be connected to the wiring connection end of the first substrate 10 via conductive silver paste. For example, a through hole is defined where the second conductive layer 40 corresponds to the second metal wire 41, and the conductive silver paste is connected with the second metal wire 41 via the through hole.

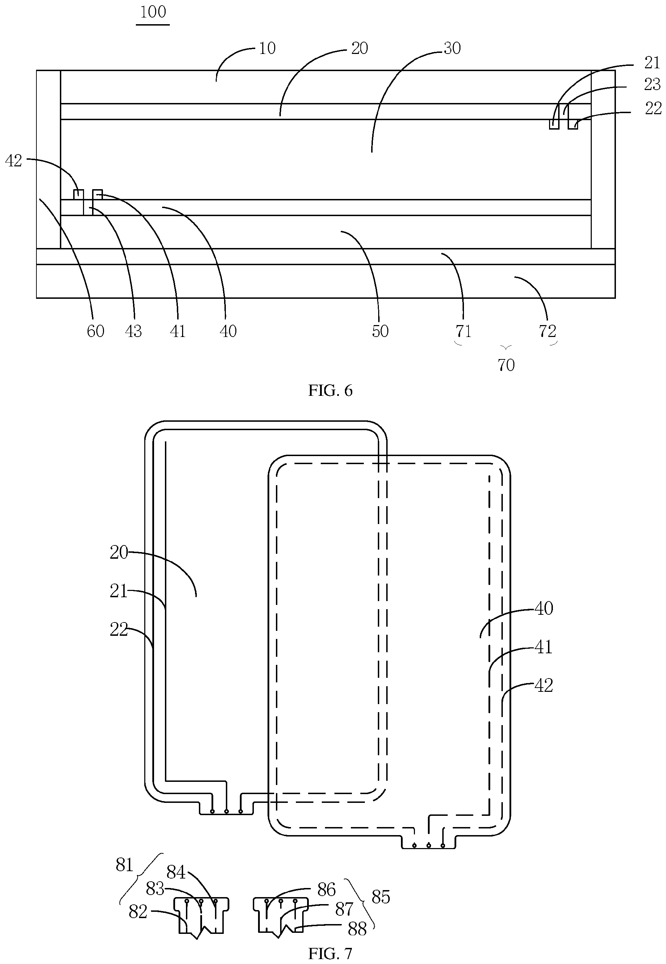

As shown in FIG. 6 and FIG. 7, FIG. 6 illustrates a schematic cross-sectional view of the electrochromic module along I-I shown in FIG. 1 according to another embodiment of the present disclosure, and FIG. 7 illustrates a schematic view of a circuit connection between the first conductive layer, the second conductive layer, and the flexible circuit board shown in FIG. 1 according to another embodiment of the present disclosure. The electrochromic module 100 may include the first substrate 10, the first conductive layer 20, the color-changing material layer 30, the second conductive layer 40, the second substrate 50, the adhesive frame 60, and the water and oxygen blocking unit 70, which are described in the above-mentioned embodiments. The first substrate 10, the first conductive layer 20, the color-changing material layer 30, the second conductive layer 40, the second substrate 50, and the water and oxygen blocking unit 70 are successively stacked. The adhesive frame 60 is disposed around the peripheral side of the color-changing material layer 30. The adhesive frame 60, the first conductive layer 20, and the second conductive layer 40 cooperatively define a chamber, and the chamber is configured to fill the color-changing material to form the color-changing material layer 30. The first substrate 10 is configured to support and carry the first conductive layer 20. The second substrate 50 is configured to support and carry the second conductive layer 40. The first substrate 10 and the second substrate 50 make the electrochromic module 100 form the complete product, such that the electrochromic module 100 may be used normally. The adhesive frame 60 and/or the water and oxygen blocking unit 70 are configured to completely isolate the electrochromic module 100, such as the color-changing material layer 30, from the external water oxygen environment, thereby reducing the oxidation failure of the color-changing material.

In an embodiment, the first metal wire 21 adopts a partial wiring method. For example, the first metal wire 21 is only arranged on a side of the first conductive layer 20, while the first ground wire 22 encloses a periphery of the first metal wire 21.

In an embodiment, the second metal wire 41 adopts a partial wiring method. For example, the second metal wire 41 is only arranged on one side of the second conductive layer 40, while the second ground wire 42 is disposed around a periphery of the second metal wire 41.

In an embodiment, the first metal wire 21 extends along an edge position close to a surface of the first conductive layer 20, and the second metal wire 41 extends along an edge position close to a surface of the second conductive layer 40.

It can be understood that, the first ground wire 22 may be either wrapped around the first metal wire 21 by using a full circumference wire, or using a partial wiring method. For example, the first ground wire 22 may be wrapped around a partial circumference of the first metal wire 21, such as on one side, two adjacent sides, or three sides. When the first ground wire 22 adopts the partial wiring method, the second ground wire 84 may be omitted.

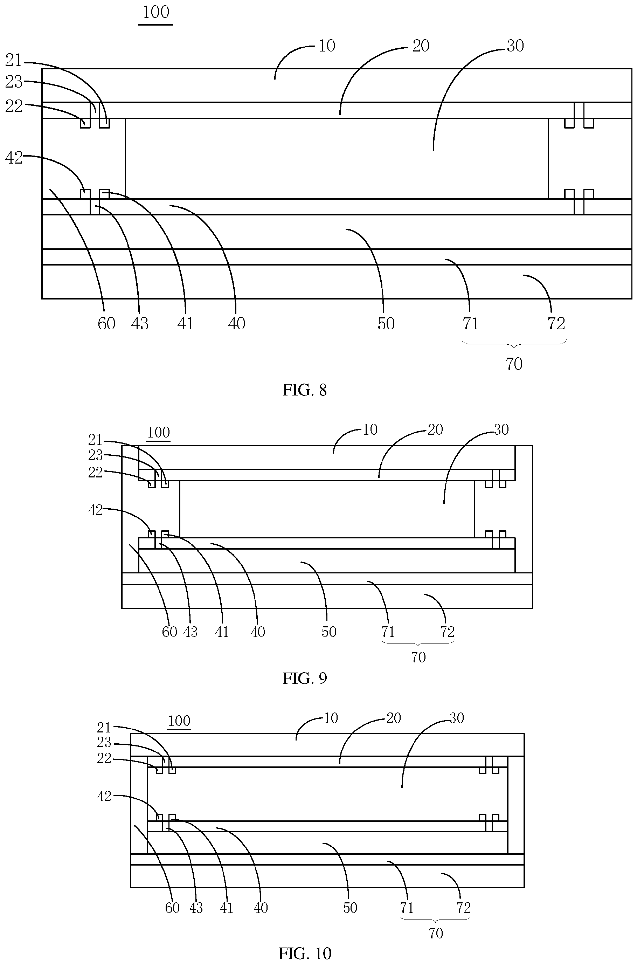

As shown in FIG. 8, FIG. 8 illustrates a schematic cross-sectional view of the electrochromic module along I-I shown in FIG. 1 according to another embodiment of the present disclosure. The electrochromic module 100 may include the first substrate 10, the first conductive layer 20, the color-changing material layer 30, the second conductive layer 40, the second substrate 50, the adhesive frame 60, and the water and oxygen blocking unit 70, which are described in the above-mentioned embodiments. The first substrate 10, the first conductive layer 20, the color-changing material layer 30, the second conductive layer 40, the second substrate 50, and the water and oxygen blocking unit 70 are successively stacked. The adhesive frame 60 is disposed around the annular side of the color-changing material layer 30. The adhesive frame 60, the first conductive layer 20, and the second conductive layer 40 cooperatively define the chamber, and the chamber is configured to fill the color-changing material to form the color-changing material layer 30. The first substrate 10 is configured to support and carry the first conductive layer 20. The second substrate 50 is configured to support and carry the second conductive layer 40. The first substrate 10 and the second substrate 50 make the electrochromic module 100 form the complete product such that the electrochromic module 100 may be used normally. The adhesive frame 60 and/or the water and oxygen blocking unit 70 are configured to completely isolate the electrochromic module 100, such as the color-changing material layer 30, from the external water oxygen environment, thereby reducing the oxidation failure of the color-changing material.

In an embodiment, the adhesive frame 60 is disposed between the first conductive layer 20 and the second conductive layer 40. The adhesive frame 60 is disposed around the annular side of the color-changing material layer 30. In an embodiment, the adhesive frame 60 may be covered on the first metal wire 21, the first ground wire 22, and the first isolation groove 23, so as to prevent the short circuiting between the first metal wire 21 and the first ground wire 22. In an embodiment, the adhesive frame 60 may be covered on the second metal wire 41, the second ground wire 42, and the second isolation groove 43, so as to prevent the short circuiting between the second metal wire 41 and the second ground wire 42.

As shown FIG. 9, FIG. 9 illustrates a schematic cross-sectional view of the electrochromic module along I-I shown in FIG. 1 according to another embodiment of the present disclosure. The electrochromic module 100 may include the first substrate 10, the first conductive layer 20, the color-changing material layer 30, the second conductive layer 40, the second substrate 50, the adhesive frame 60, and the water and oxygen blocking unit 70, which is described in the above-mentioned embodiments. The first substrate 10, the first conductive layer 20, the color-changing material layer 30, the second conductive layer 40, the second substrate 50, and the water and oxygen blocking unit 70 are successively stacked. The adhesive frame 60 is disposed around the annular side of the color-changing material layer 30. The adhesive frame 60, the first conductive layer 20, and the second conductive layer 40 cooperatively define the chamber, and the chamber is configured to fill the color-changing material to form the color-changing material layer 30. The first substrate 10 is configured to support and carry the first conductive layer 20. The second substrate 50 is configured to support and carry the second conductive layer 40. The first substrate 10 and the second substrate 50 make the electrochromic module 100 form the complete product, such that the electrochromic module 100 may be used normally. The adhesive frame 60 and/or the water and oxygen blocking unit 70 are configured to completely isolate the electrochromic module 100, such as the color-changing material layer 30, from the external water oxygen environment, so as to reduce the oxidation failure of the color-changing material.

In an embodiment, the adhesive frame 60 may be disposed around the annular side of the first substrate 10, the first conductive layer 20, the color-changing material layer 30, the second conductive layer 40, and the second substrate 50. Further, the adhesive frame 60 may be adhered to the first substrate 10, the first conductive layer 20, the color-changing material layer 30, the second conductive layer 40, and the second substrate 50, respectively. The adhesive frame 60 is partially disposed between the first conductive layer 20 and the second conductive layer 40. In an embodiment, the adhesive frame 60 may be covered on the first metal wire 21, the first ground wire 22, and the first isolation groove 23, so as to prevent the short circuiting between the first metal wire 21 and the first ground wire 22. In an embodiment, the adhesive frame 60 may be covered on the second metal wire 41, the second ground wire 42 and the second isolation groove 43, so as to prevent the short circuiting between the second metal wire 41 and the second ground wire 42.

As shown in FIG. 10, FIG. 10 illustrates a schematic cross-sectional view of the electrochromic module along I-I shown in FIG. 1 according to another embodiment of the present disclosure. The electrochromic module 100 may include the first substrate 10, the first conductive layer 20, the color-changing material layer 30, the second conductive layer 40, the second substrate 50, the adhesive frame 60, and the water and oxygen blocking unit 70, which are described in the above-mentioned embodiments. the first substrate 10, the first conductive layer 20, the color-changing material layer 30, the second conductive layer 40, the second substrate 50, and the water and oxygen blocking unit 70 are successively stacked. The adhesive frame 60 is disposed around the annular side of the color-changing material layer 30. The adhesive frame 60, the first conductive layer 20, and the second conductive layer 40 cooperatively define the chamber, and the chamber is configured to fill the color-changing material to form the color-changing material layer 30. The first substrate 10 is configured to support and carry the first conductive layer 20. The second substrate 50 is configured to support and carry the second conductive layer 40. The first substrate 10 and the second substrate 50 make the electrochromic module 100 form the complete product such that the electrochromic module 100 may be used normally. The adhesive frame 60 and/or the water and oxygen blocking unit 70 are configured to completely isolate the electrochromic module 100, such as the color-changing material layer 30, from the external water oxygen environment, so as to reduce the oxidation failure of the color-changing material.

In an embodiment, the adhesive frame 60 may be disposed around the peripheral side of the first conductive layer 20, the color-changing material layer 30, the second conductive layer 40, and the second substrate 50. An end portion of the adhesive frame 60 away from a side of the second substrate 50 is adhered to a side of the first substrate 10 facing towards the color-changing material layer 30. An end portion of the adhesive frame 60 away from a side of the first substrate 10 is adhered to a side of the water and oxygen blocking unit 70, such as the water and oxygen blocking layer 71, facing towards the color-changing material layer 30.

As shown FIGS. 11-14, FIG. 11, FIG. 12, FIG. 13, and FIG. 14 respectively illustrate schematic cross-sectional views of the electrochromic module along I-I shown in FIG. 1 according to some embodiments of the present disclosure. The electrochromic module 100 may include the first substrate 10, the first conductive layer 20, the color-changing material layer 30, the second conductive layer 40, the second substrate 50, the adhesive frame 60, and the water and oxygen blocking unit 70, which are described in the above-mentioned embodiments. The first substrate 10, the first conductive layer 20, the color-changing material layer 30, the second conductive layer 40, the second substrate 50, and the water and oxygen blocking unit 70 are successively stacked. The adhesive frame 60 is disposed around the annular side of the color-changing material layer 30. The adhesive frame 60, the first conductive layer 20, and the second conductive layer 40 cooperatively define the chamber, and the chamber is configured to fill the color-changing material to form the color-changing material layer 30. The first substrate 10 is configured to support and carry the first conductive layer 20. The second substrate 50 is configured to support and carry the second conductive layer 40. The first substrate 10 and the second substrate 50 make the electrochromic module 100 form the complete product such that the electrochromic module 100 may be used normally. The adhesive frame 60 and/or the water and oxygen blocking unit 70 are configured to completely isolate the electrochromic module 100, such as the color-changing material layer 30, from the external water oxygen environment, so as to reduce the oxidation failure of the color-changing material.

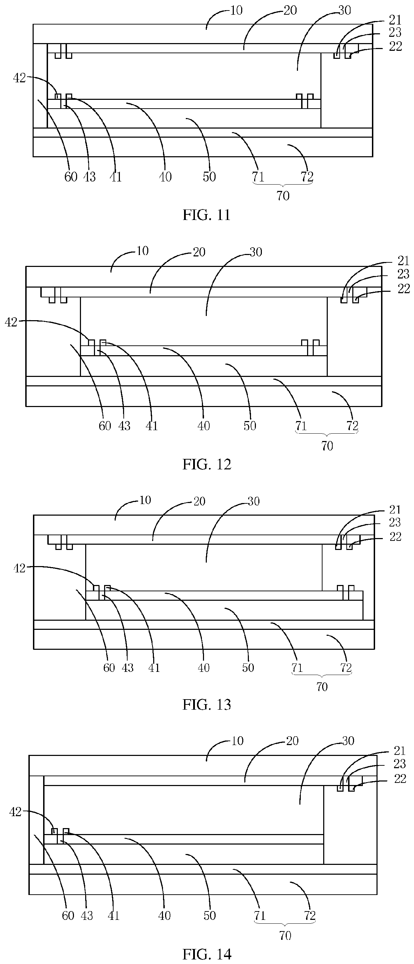

In an embodiment, the adhesive frame 60 may be disposed around the side ring of the first conductive layer 20, the color-changing material layer 30, the second conductive layer 40, and the second substrate 50. The end portion of the adhesive frame 60 away from the side of the second substrate 50 is adhered to the side of the first substrate 10 facing towards the color-changing material layer 30. The end portion of the adhesive frame 60 away from the side of the first substrate 10 is adhered to the side of the water and oxygen blocking unit 70, such as the water and oxygen blocking layer 71, facing towards the color-changing material layer 30. In an embodiment, as shown in FIG. 11, a part of the first conductive layer 20 facing towards a side surface of the color-changing material layer 30 is adhered to the adhesive frame 60. A part of the adhesive frame 60 adhered to the side surface of the first conductive layer 20 facing towards the color-changing material layer 30 may be covered on a part of the first metal wire 21, a part of the first ground wire 22, and a part of the first isolation groove 23, so as to prevent the short circuiting between the first metal wire 21 and the first ground wire 22. In an embodiment, as shown in FIG. 12, a part of the first conductive layer 20 facing towards a side surface of the color-changing material layer 30 is adhered to the adhesive frame 60. A part of the adhesive frame 60 adhered to the side surface of the first conductive layer 20 facing towards the color-changing material layer 30 may be covered on the entire first metal wire 21, the entire first ground wire 22, and the entire first isolation groove 23, so as to prevent the short circuiting between the first metal wire 21 and the first ground wire 22. In an embodiment, as shown in FIG. 13, a part of the first conductive layer 20 facing towards the side surface of the color-changing material layer 30 is adhered to the adhesive frame 60. The part of the second conductive layer 40 facing towards the side surface of the color-changing material layer 30 is adhered to the adhesive frame 60. A part of the adhesive frame 60 adhered to the side surface of the first conductive layer 20 facing towards the color-changing material layer 30 may be covered on the entire first metal wire 21, the entire first ground wire 22, and the entire first isolation groove 23, so as to prevent the short circuiting between the first metal wire 21 and the first ground wire 22. A part of the adhesive frame 60 adhered to the side surface of the second conductive layer 40 facing towards the color-changing material layer 30 may be covered on a part of the second metal wire 41, a part of the second ground wire 42, and a part of the second isolation groove 43, so as to prevent the short circuiting between the second metal wire 41 and the second ground wire 42.

It can be understood that, the first circuit wiring 21, the first ground wire 22, the second circuit wiring 41, and the second ground wire 42 may all adopt the wiring arrangement shown in FIG. 7, such that the first circuit wiring 21 and the first ground wire 22 are covered by the adhesive frame 60, and thus the second circuit wiring 41 and the second ground wire 42 are disposed between the color-changing material layer 30 and the second conductive layer 40. For example, as shown in FIG. 14, the part of the first conductive layer 20 facing towards the side surface of the color-changing material layer 30 is adhered to the adhesive frame 60. The part of the second conductive layer 40 facing towards the side surface of the color-changing material layer 30 is adhered to the adhesive frame 60. A part of the adhesive frame 60 adhered to the side surface of the first conductive layer 20 facing towards the color-changing material layer 30 may be covered on the entire first metal wire 21, the entire first ground wire 22, and the entire first isolation groove 23, so as to prevent the short circuiting between the first metal wire 21 and the first ground wire 22. The second metal wire 41, the second ground wire 42, and the second isolation groove 43 are disposed between the color-changing material layer 30 and the second conductive layer 40. Of course, the second metal wire 41, the second ground wire 42, and the second isolation groove 43 may also be completely covered by the adhesive frame 60.

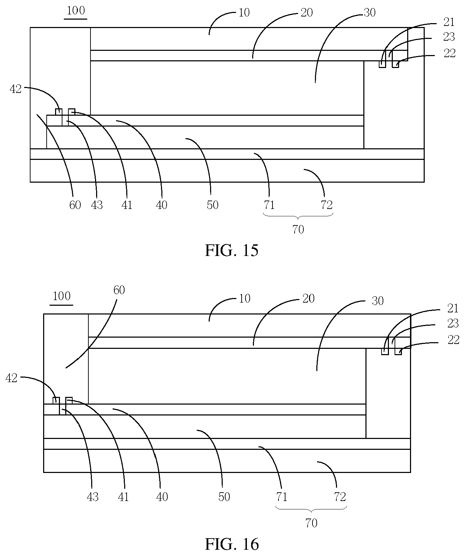

As shown in FIG. 15 and FIG. 16, FIG. 15 and FIG. 16 respectively illustrate a schematic cross-sectional view of the electrochromic module along I-I shown in FIG. 1 according to another embodiment of the present disclosure. The electrochromic module 100 may include the first substrate 10, the first conductive layer 20, the color-changing material layer 30, the second conductive layer 40, the second substrate 50, the adhesive frame 60, and the water and oxygen blocking unit 70, which are described in the above-mentioned embodiments. The first substrate 10, the first conductive layer 20, the color-changing material layer 30, the second conductive layer 40, the second substrate 50, and the water and oxygen blocking unit 70 are successively stacked. The adhesive frame 60 is disposed around the annular side of the color-changing material layer 30. The adhesive frame 60, the first conductive layer 20, and the second conductive layer 40 cooperatively define the chamber, and the chamber is configured to fill the color-changing material to form the color-changing material layer 30. The first substrate 10 is configured to support and carry the first conductive layer 20. The second substrate 50 is configured to support and carry the second conductive layer 40. The first substrate 10 and the second substrate 50 make the electrochromic module 100 form the complete product such that the electrochromic module 100 may be used normally. The adhesive frame 60 and/or the water and oxygen blocking unit 70 are configured to completely isolate the electrochromic module 100, such as the color-changing material layer 30, from the external water oxygen environment, so as to reduce the oxidation failure of the color-changing material.

In an embodiment, the first conductive layer 20 and the second conductive layer 40 are arranged in a staggered manner. The color-changing material layer 30 is arranged corresponding to an overlapped area between an orthographic projection of the first conductive layer 20 and an orthographic projection of the second conductive layer 40. The first metal wire 21, the first ground wire 22, and the first isolation groove 23 are disposed outside of the orthographic projection of the second conductive layer 40 projected on the first conductive layer 20. The second metal wire 41, the second ground wire 42, and the second isolation groove 43 are disposed outside of the orthographic projection of the first conductive layer 20 projected on the second conductive layer 40. The adhesive frame 60 may be disposed around the annular side of the first substrate 10, the first conductive layer 20, the color-changing material layer 30, the second conductive layer 40, and the second substrate 50. In an embodiment, the adhesive frame 60 may be covered on the first metal wire 21, the first ground wire 22, and the first isolation groove 23, so as to prevent the short circuiting between the first metal wire 21 and the first ground wire 22. In an embodiment, the adhesive frame 60 may be covered on the second metal wire 41, the second ground wire 42, and the second isolation groove 43, so as to prevent the short circuiting between the second metal wire 41 and the second ground wire 42.

It can be understood that, the first conductive layer 20 and the second conductive layer 40 are arranged in a staggered manner, such that it is possible to reduce the risk that the wires of the first conductive layer 20 and the second conductive layer 40 (that is, the first metal wire 21 and the first ground wire 22, the second metal wire 41, and the second ground wire 42) contact each other. A wiring step may be easily realized by means of dispensing silver paste after the first conductive layer 20 and the second conductive layer 40 are assembled, thereby reducing the risk of short circuiting and the difficulty of production process. According to a design of a structure, a shape of the wire may be linear, L-shaped, zigzag, or the like.

In an embodiment, as shown in FIG. 16, the adhesive frame 60 may be covered on the first metal wire 21, the first ground wire 22, and the first isolation groove 23, and a side edge of the adhesive frame 60 is flush with a side edge of the first substrate 10. In an embodiment, the adhesive frame 60 may be covered on the second metal wire 41, the second ground wire 42, and the second isolation groove 43, and the side edge of the adhesive frame 60 is flush with a side edge of the second substrate 50.

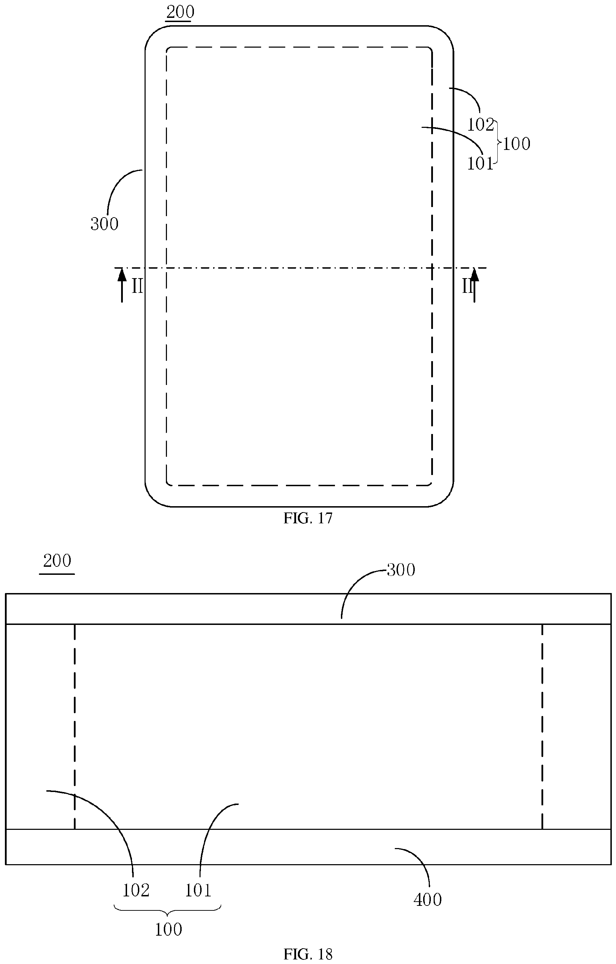

In the following, a cover plate assembly is described. The cover plate assembly includes the electrochromic module 100 described in the above-mentioned embodiment, and the electrochromic module 100 may be configured to realize an active change of an appearance of the cover plate assembly, so as to significantly improve appearance expression of the cover plate assembly. As shown in FIG. 17 and FIG. 18, FIG. 17 illustrates a top view of a cover plate assembly according to an embodiment of the present disclosure, and FIG. 18 illustrates a schematic cross-sectional view of the cover plate assembly along II-II shown in FIG. 17 according to an embodiment of the present disclosure. The cover plate assembly 200 may include the electrochromic module 100, a cover plate 300, and a decorative unit 400 (also referred to as an appearance-affecting film layer). The cover plate 300, the electrochromic module 100, and the decorative unit 400 are successively stacked. The decorative unit 400 may be displayed or shielded through changing color (coloring or discoloring) of the electrochromic module 100, such that the appearance effect of the cover plate assembly 200 may be actively changed, thereby significantly improving the appearance expression of the cover plate assembly 200.

As shown in FIG. 17 and FIG. 18, the electrochromic module 100 may include a color-changing portion 101 and an encapsulation portion 102 in an integrated structure. The encapsulation portion 102 may be disposed around the color-changing portion 101. The encapsulation portion 102 may be formed by encapsulating the color-changing portion 101 via the adhesive frame 60 in the above-mentioned embodiment, or encapsulating the color-changing portion 101 via the adhesive frame 60 and other materials of the electrochromic module 100, that is, the encapsulation portion 102 is an area that is neither colored nor discolored after the electrochromic module 100 is energized. The color-changing portion 101 is an area that is colored or discolored by controlling the voltage after the electrochromic module 100 is energized. According to the introduction of the electrochromic module 100 in the above-mentioned embodiments, the wire (such as the first metal wire 21, the second metal wire 41, the first ground wire 22, and the second ground wire 42) and the isolation groove (such as the first isolation groove 23, the second isolation groove 43) may be arranged in the color-changing portion 101 and/or the encapsulation portion 102.

It can be understood that, the function of the electrochromic module 100 needs to be driven by an electrical signal (that is, a control voltage). Therefore, the edge of the electrochromic module 100 is provided with the encapsulation portion 102, such as the adhesive frame 60 (that is, the adhesive frame 60 is transparent in an ideal state, and there is a slight whitening phenomenon), the wire (a silver white metal wire of the first metal wire 21, the second metal wire 41, the first ground wire 22, or the second ground wire 42), and the tawny flexible circuit board 80, which are inconsistent with the appearance of the electrochromic module 100 and are exposed under the transparent cover plate 300, affecting the appearance expression of the cover plate assembly 200. In this case, it is necessary to arrange a shielding layer in the cover plate assembly 200 to shield a structure that is not suitable for displaying through the cover plate 300, such as the adhesive frame 60, the wire (that is, the silver white metal wire of the first metal wire 21, the second metal wire 41, the first ground wire 22, or the second ground wire 42), the isolation grooves, etc.

As shown in FIGS. 19-21, FIG. 19, FIG. 20 and FIG. 21 respectively illustrate structural schematic views of a cover plate according to different embodiments of the present disclosure. The cover plate 300 may be adhered to the electrochromic module 100, such as the first substrate 10. In an embodiment, the cover plate 300 may be adhered to the electrochromic module 100, such as the first substrate 10, via the transparent optical adhesive. That is, the OCA optical adhesive layer may also be arranged between the cover plate 300 and the electrochromic module 100, such as the first substrate 10.

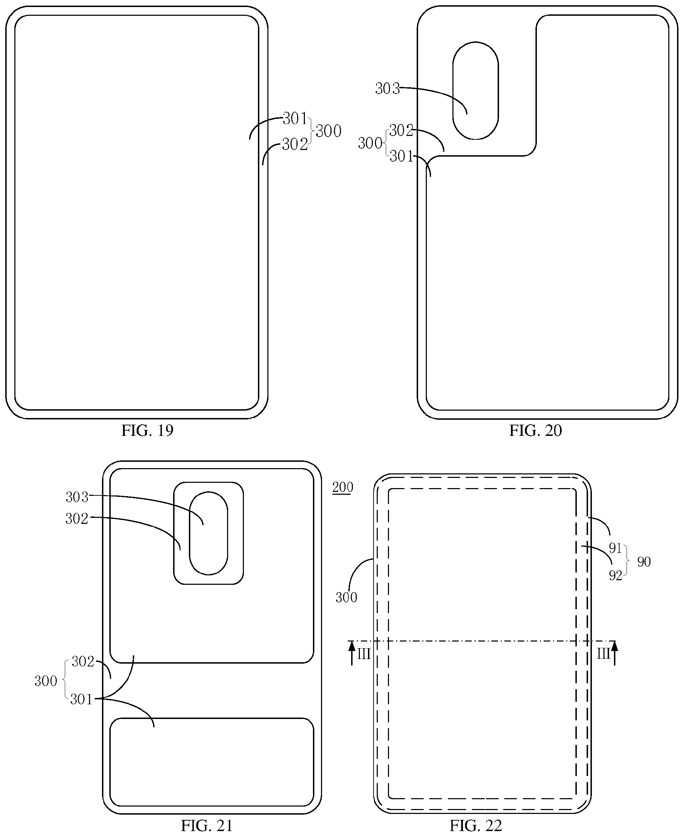

In an embodiment, the cover plate 300 may be made of a light transmitting material, such as glass (transparent glass, AG glass, etc.), plastic, transparent polycarbonate (PC), transparent PC/PMMA composite board, and so on. Of course, the cover plate 300 may also be spliced by the light transmitting material and an opaque material (that is, the cover plate 300 is partially transparent). Specifically, the opaque material may be made by mixing the light transmitting material with other materials, or may be only the opaque material. The opaque material may be the plastic, the glass, and other materials. Of course, as long as materials with a certain hardness are classified according to light transmittance, the materials may be divided into the light transmitting material and the opaque material. The entire cover plate 300 is transparent, and thus the cover plate 300 may also be called "a transparent cover plate". In an embodiment, as shown in FIGS. 19-21, the cover plate 300 may include a transparent region 301 and an opaque region 302. The transparent region 301 and the opaque region 302 may be arranged at will, or various patterns may be arranged as required. It can be understood that, the transparent region 301 may be made of the light transmitting material, while the opaque region 302 may be made of the opaque material. A light transmittance of the transparent region 301 may be determined by different light transmitting materials. In an embodiment, as shown in FIG. 19 and FIG. 20, the opaque region 302 surrounds the transparent region 301. In an embodiment, as shown in FIG. 21, the transparent region 301 may be divided into two parts, and the opaque region 302 surrounds the transparent region 301. Of course, the transparent region 301 may also be divided into other parts, which is not limited herein. Similarly, the opaque region 302 may also be divided into at least one part, which is not limited herein. In an embodiment, as shown in FIGS. 20-23, FIG. 23 illustrates a top view of the cover plate assembly according to another embodiment of the present disclosure, an imaging hole 303 may be defined on the opaque region 302. The imaging hole 303 is configured for matching with a camera module. It can be understood that, an arrangement of the transparent region 301 and the opaque region 302 is not limited by the arrangement forms listed here. The arrangement forms listed here are only examples, which may also be other arrangement forms.

As shown in FIGS. 22-24, FIG. 24 illustrates a schematic cross-sectional view of the cover plate assembly along III-III shown in FIG. 22 according to an embodiment of the present disclosure. A shielding layer 90 is arranged on a side of the cover plate 300 facing towards the electrochromic module 100, such as the first substrate 10. The shielding layer 90 is configured for shielding the encapsulation portion 102, the wire, etc., of the electrochromic module 100. In an embodiment, an orthographic projection region of the shielding layer 90 projected on the cover plate 300 may be partially located in the opaque region 302 and partially located in the transparent region 301. Of course, it can be understood that, the shielding layer 90 is arranged based on the encapsulation portion 102, the wire, etc., of the electrochromic module 100. Therefore, the orthographic projection region of the shielding layer 90 projected on the cover plate 300 may be all located in the transparent region 301, or all located in the opaque region 302. When the orthographic projection region of the shielding layer 90 projected on the cover plate 300 is all located in the opaque region 302, the shielding layer 90 cannot play the role of shielding, and thus the shielding layer 90 may be omitted.

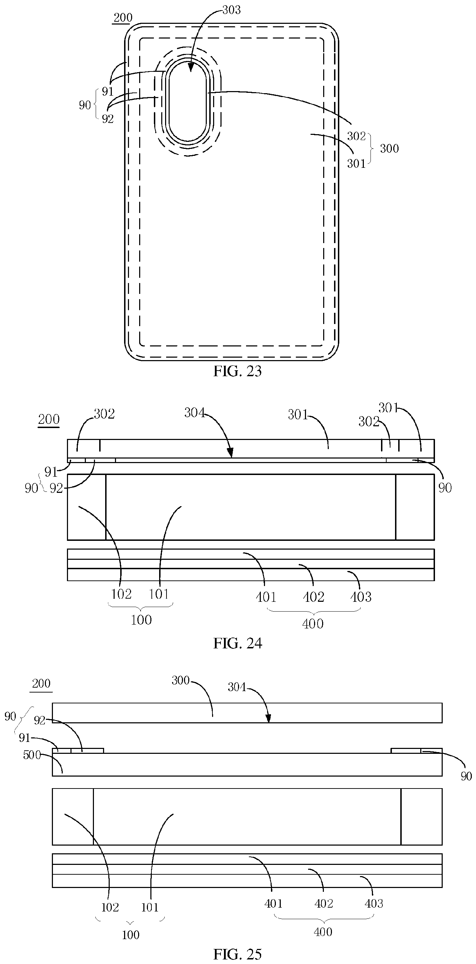

In an embodiment, as shown in FIG. 24, during forming process of the electrochromic module 100 and other structures, there may be wrinkles, heterochromatic spots, and other structures that affect appearance, and the wrinkles, the heterochromatic spots, and other structures that affect appearance may also be exposed under the transparent cover plate 300. In order to solve a problem of the wrinkles, the heterochromatic spots, and other structure that affect appearance, a matte surface 304 is arranged on a surface at a side of the cover plate 300 close to the electrochromic module 100, such as the first substrate 10. By arranging the matte surface 304 on the surface of the cover plate 300, the light transmittance of the cover plate 300 is changed, such that the user cannot observe the wrinkles, the heterochromatic spots, and other structures that affect appearance in the outside through the matte surface 304, without affecting imaging of other structures through the electrochromic module 100. Of course, a surface at a side of the cover plate 300 away from the electrochromic module 100, such as the first substrate 10, may also be provided with the matte surface. In an embodiment, the matte surface may only be arranged where the transparent region 301 is opposite to the cover plate 300. In an embodiment, the haze of the matte surface 304 may be in a range from 65% to 85%. In an embodiment, the roughness of the cover plate 300 on the matte surface 304 may be in a range from 0.1 µm to 2.0 µm. Of course, in some embodiments, the roughness may be in a range from 0.2 µm to 0.3 µm. In an embodiment, the matte surface 304 of the cover plate 300 is formed by a process of sanding, frosting, hydrofluoric acid etching, sand blasting, liquid medicine sand, or the like.

In an embodiment, the shielding layer 90 may be a coating film. For example, the coating film may be one of a mixed layer consisting of an indium layer, a silicon dioxide layer, and a titanium trioxide layer, and a mixed layer consisting of a silicon dioxide layer and a niobium oxide layer. In an embodiment, the coating film may be a gradient coating film, and the coating film gradually changes from a middle of the coating film to an edge of the coating film, or gradually changes from an edge at one side of the coating film to the edge at an opposite side of the coating film.

In an embodiment, the coating film may be formed by the vacuum evaporation method or magnetron sputtering method. A metal thin film or an oxide thin film may be coated on an area of the cover plate 300 to be shielded (that is, generally an outer edge of the cover plate 300 and an area of the imaging hole 303). The encapsulation portion 102, the wire, etc., are shielded by a thin film of nearly-opaque (a width, a thickness, a color, a solid color, or a gradient effect of the film may be designed as required).

In an embodiment, the shielding layer 90 may be a colored ink layer. Colorful ink or pigments may be attached to the area of the cover plate 300 to be shielded (that is, generally an outer edge of the cover plate 300 and an area of the imaging hole 303) by means of spraying, silk screen printing, pad printing, or electroplating. The encapsulation portion 102, the wire, etc., are shielded by the opaque material (a width, a thickness, a color, a solid color, or a gradient effect of the material may be designed as required). In an embodiment, the colored ink layer may be a black edge, such as a silkscreen black edge.

In an embodiment, as shown in FIG. 22 and FIG. 24, the shielding layer 90 may include a first light-shielding portion 91 and a second light-shielding portion 92. The first light-shielding portion 91 and the second light-shielding portion 92 may be an integrated structure. The first light-shielding portion 91 is in an annular shape. The first light-shielding portion 91 surrounds a periphery of the second light-shielding portion 92, and the first light-shielding portion 91 adjoins the second light-shielding portion 92. In an embodiment, the first light-shielding portion 91 may be formed via the following operations: a film is coated on a surface of the cover plate 300 by means of Non Conductive Vapor Metallization process, and then a film layer in a region of the first light-shielding portion 91 is coated, exposed, developed, etched with yellow light, and photoresist removing is performed. Of course, one of the materials of TIO₂, TA₂O₅, NB₂O₅, ZRO₂, etc., may further be evaporated on a surface of the cover plate 300 to form an anti-fingerprint film with high light transmittance. The first light-shielding portion 91 finally formed may be a black edge. Of course, the first light-shielding portion 91 may also be the colored ink layer in the above-mentioned embodiments. The light-shielding portion 92 may be formed by coating indium, coating aluminum powder, or pad printing the aluminum powder, and a color of the light-shielding portion 92 may be consistent with a color of the electrochromic module after coloring, so as to enhance the appearance expression. In an embodiment, one of the first light-shielding portion 91 and the second light-shielding portion 92 may be omitted.

In an embodiment, as shown in FIG. 25, FIG. 25 illustrates a schematic cross-sectional view of the cover plate assembly along III-III shown in FIG. 22 according to another embodiment of the present disclosure. The cover plate assembly 200 further includes a fourth substrate 500, and the fourth substrate 500 is stacked between the electrochromic module 100 and the cover plate assembly 300. The shielding layer 90 may include a coating film. For example, the coating may be one of the mixed layer consisting of the indium layer, the silicon dioxide layer and the titanium pentoxide layer, or the mixed layer consisting of the silicon dioxide layer and the niobium oxide layer. In an embodiment, the coating film may be the gradient coating film, and the coating film gradually changes from the middle of the coating film to the edge of the coating film, or gradually changes from the edge of the one side of the coating film to the edge of the opposite side of the coating film. In an embodiment, the coating film is arranged on a side of the fourth substrate 500 away from the first substrate 10. The fourth substrate 500 is adhered to the first substrate 10, for example, via the transparent optical adhesive. That is, the OCA optical adhesive layer may also be arranged between the first substrate 10 and the second substrate 50. In an embodiment, the coating film is arranged on the side of the fourth substrate 500 away from the cover plate 300. The cover plate 300 is adhered to the fourth substrate 500, for example, via the transparent optical adhesive. That is, the OCA optical adhesive layer may be arranged between the cover plate 300 and the fourth substrate 500. In an embodiment, the fourth substrate 500 may also be used as a part of the shielding layer 90.

In an embodiment, the shielding layer 90 shown in FIG. 25 may also be arranged according to the shielding layer 90 shown in FIG. 24 including the first light-shielding portion 91 and the second light-shielding portion 92. For details, it may refer to those recited in FIG. 24, which will not be repeated here.

It can be understood that, the names of "first substrate", "second substrate", "third substrate", "fourth substrate", "fifth substrate", and "substrate" may be converted to each other in different embodiments. In an embodiment, for example, "first substrate" may also be referred to as "second substrate" or "substrate".

In an embodiment, the coating film may be formed by the vacuum evaporation method or magnetron sputtering method. A metal thin film or an oxide thin film may be coated on an area of the fourth substrate 500 to be shielded. The encapsulation portion 102, the wire, etc., are shielded by the thin film of nearly-opaque (the width, the thickness, the color, the solid color, or the gradient effect of the film may be designed as required).

In an embodiment, the shielding layer 90 may be a colored ink layer. Colorful ink or pigments may be attached to the area of the fourth substrate 500 to be shielded (that is, generally an outer edge of the cover plate 300 and an area of the imaging hole 303) by means of spraying, silk screen printing, pad printing, or electroplating. The encapsulation portion 102, the wire, etc., are shielded by the opaque material (a width, a thickness, a color, a solid color, or a gradient effect of the material may be designed as required).

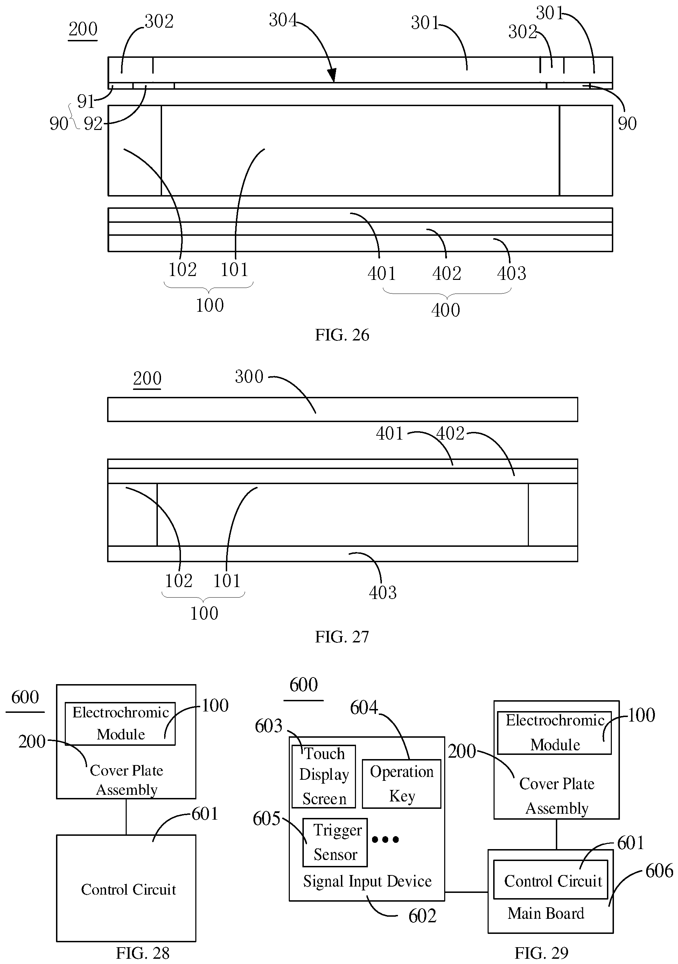

In an embodiment, as shown in FIG. 26, FIG. 26 illustrates a schematic cross-sectional view of the cover plate assembly along III-III shown in FIG. 22 according to another embodiment of the present disclosure. The shielding layer 90 may be a coating film, for example, the coating film may be one of a mixed layer consisting of an indium layer, a silicon dioxide layer, and a titanium trioxide layer, and a mixed layer consisting of a silicon dioxide layer and a niobium oxide layer. In an embodiment, the coating film may be a gradient coating film, and the coating film gradually changes from a middle of the coating film to an edge of the coating film, or gradually changes from an edge of one side of the coating film to the edge of an opposite side of the coating film. The shielding layer 90 is arranged on the electrochromic module 100, such as the first substrate 10.

In an embodiment, the coating film may be formed by the vacuum evaporation method or magnetron sputtering method. A metal thin film or an oxide thin film may be coated on an area of the first substrate 10 to be shielded. The encapsulation portion 102, the wire, etc., are shielded by the thin film of nearly-opaque (the width, the thickness, the color, the solid color, or the gradient effect of the film may be designed as required).

In an embodiment, the shielding layer 90 shown in FIG. 26 may also be arranged according to the shielding layer 90 shown in FIG. 24 including the first light-shielding portion 91 and the second light-shielding portion 92. For details, it may refer to those recited in FIG. 24, which will not be repeated here.

It can be understood that, when the cover plate 300 is provided with the transparent region 301 and the opaque region 302, the arrangement of the transparent region 301 and the opaque region 302 may be similar to that of the transparent region 301 and the opaque region 302 shown in FIG. 20 and FIG. 21. At this time, the shading layer 90 may include the first light-shielding portion 91 and the second light-shielding portion 92. The first light-shielding portion 91 and the second light-shielding portion 92 are arranged side by side and adjoining each other. In order to shield the wire, namely, the encapsulation portion 102, a shape of the shielding layer 90 may be strip, irregular, and non-closed loop. Therefore, the first light-shielding portion 91 is arranged on a side of the light-shielding portion 92, and the first light-shielding portion 91 and the light-shielding portion 92 are disposed in the orthographic projection region of the electrochromic module 100. The first light-shielding portion 91 is closer to the encapsulation portion 102 than the light-shielding portion 92, and the light-shielding portion 92 is closer to the color-changing portion 101 than the first light-shielding portion 91.

As shown in FIG. 18 and FIGS. 24-26, the decorative unit 400 may include a nano-imprinting layer 401, a color layer 402, and a primer 403. The nano-imprinting layer 401, the color layer 402 and the primer 403 are successively stacked on one another. A side of the nano-imprinting layer 401 away from the color layer 402 may be adhered to a side of the electrochromic module 100, such as the second substrate 50 or the third substrate 72, away from the color-changing material layer 30. It can be understood that, the nano-imprinting layer 401 may also be disposed between the color layer 402 and the primer 403, that is, the color layer 402, the nano-imprinting layer 401, and the primer 403 may be successively stacked on one another.

It can be understood that, the water and oxygen blocking layer 71 is arranged on a side of the third substrate 72 of the water and oxygen blocking unit 70 close to the color-changing material layer 30. The water and oxygen blocking layer 71 is arranged on the side of the third substrate 72 close to the color-changing material layer 30 rather than a side away from the color-changing material layer 30, so as to prevent some scratches caused by the water and oxygen blocking layer 71 facing outward. In addition, the water and oxygen blocking layer 71 cannot be arranged between the third substrate 72 and the nano-imprinting layer 401. On the one hand, the water and oxygen blocking layer 71 affects a binding force between the nano-imprinting layer 401 and the third substrate 72. Further, if the water and oxygen blocking layer 71 is directly contacted during nano-imprinting process, the water and oxygen blocking layer 71 may be damaged. The water vapor transmittance (WVTR) of the water oxygen barrier 71 is less than 1×10⁻²g/m²/day (20°C/100% RH). The nano-imprinting layer 401 and the color layer 402 are arranged on the side of the third substrate 72 away from the water and oxygen blocking layer 71. The color layer 402 may be formed by means of optical coating, printing, printing plus coating, or the like. The nano-imprinting layer 401 and the color layer 402 are main carriers of the decorative unit 400 representing the decorative effect. Apart under the nano-imprinting layer 401 and the color layer 402 is the primer 403 (namely, ink). The structures of the nano-imprinting layer 401 and the color layer 402 may be exchanged.

As shown in FIG. 27, FIG. 27 illustrates a schematic cross-sectional view of the cover plate assembly along III-III shown in FIG. 22 according to another embodiment of the present disclosure. In the cover plate assembly 200, a shielding layer 90 may be omitted. The decorative unit 400 may include the nano-imprinting layer 401, the color layer 402, and the primer 403. The nano-imprinting layer 401 and the color layer 402 may be successively stacked on a side of the first substrate 10 of the electrochromic module 100 away from the color-changing material layer 30, that is, the nano-imprinting layer 401, the color layer 402, and the first substrate 10 may be successively stacked on one another. Alternatively, the color layer 402, the nano-imprinting layer 401, and the first substrate 10 may be successively stacked on one another. Of course, the nano-imprinting layer 401 and the color layer 402 may be stacked on the fourth substrate 500 of the cover plate assembly 200. In an embodiment, the primer 403 is stacked on the second substrate 50 or the third substrate 72 of the electrochromic module 100.

It can be understood that, a fourth substrate is further arranged between the first substrate 10 and the cover plate 300. A gradual nano-printing texture effect may be presented on the fourth substrate, thereby shielding the frame glue and the wire. The fourth substrate is respectively adhered to the cover plate 300 and the first substrate 10 via the transparent optical adhesive. The gradient texture of the fourth substrate, and the nano-imprinting layer 401 and the color layer 402 of the water and oxygen blocking unit 70 cooperatively present the appearance decoration of the encapsulating and wiring regions. In this way, depending on a stable encapsulating cycle of the water and oxygen blocking unit 70, the cover plate 300, and the edge of the adhesive frame 60, unattractive appearance regions of the wire, the adhesive frame 60, etc. are shielded by the nano-imprinting layer 401, the color layer 402, and the texture effect of nano printing, so as to continuously provide a pleasing and variable color appearance.

In the following, an electronic device is described. The electronic device uses the electrochromic module 100 or the cover plate assembly 200 in the above-mentioned embodiment as a part of a housing. The electronic device may be a mobile terminal, or other electronic devices with displaying and shooting functions. Specifically, the electronic device may be a mobile phone, a tablet, a laptop, a smart bracelet, a smart watch, a smart helmet, smart glasses, etc. In the embodiments of the present disclosure, the mobile phone is described as an example. It can be understood that, a specific form of the electronic device may also be other forms, which is not limited herein. As shown in FIG. 28, FIG. 28 illustrates a block diagram of a structure of an electronic device according to an embodiment of the present disclosure. The electronic device 600 may include a middle frame (not shown), a display module (not shown), a control circuit 601, and the cover plate assembly 200. Specifically, the middle frame and the cover plate assembly 200 are assembled into the housing, and the housing defines an accommodation space, that is, the middle frame is fixedly connected to the cover plate 300 to define the accommodation space. The housing is configured to carry the display module and the control circuit 601. The control circuit 601 (which may include the above-mentioned flexible circuit board 80) is coupled with the electrochromic module 100 of the cover plate assembly 200. The control circuit 601 is configured to receive a control instruction, and the control instruction is configured to control the electrochromic module 100 to change color. Of course, the accommodation space of the housing may also be configured to accommodate electronic members, such as a battery, a main board 606, a processor (the processor may be arranged on the main board 606), various types of sensors (the sensors, such as a temperature sensor, may also be arranged on the main board 606 and other positions of the accommodation space). In an embodiment, the display module and the cover plate assembly 200 are respectively disposed on two opposite sides of the middle frame, and are fixedly connected with the middle frame, respectively. The electrochromic module 100 is closer to the display module than the cover plate 300.

It can be understood that, in the electronic device 600, the main board 606 is a main hardware. Therefore, the above-mentioned control circuit 601 may be arranged on the main board 606, and the main board 606 may be electrically connected with (or coupled with) the electrochromic module 100 via the flexible circuit board 80. When using a layout of the first ground wire 22 and the second ground wire 42 shown in FIG. 2, FIG. 3, and FIG. 7, the mainboard, the electronic members arranged on the mainboard 606, and the control circuit 601 may be prevented from being damaged by static electricity, and thus the electronic device 600 may be prevented from being damaged by static electricity.

In an embodiment, as shown in FIG. 29, FIG. 29 illustrates a block diagram of a structure of the electronic device 600 according to another embodiment of the present disclosure. Different from the electronic device described in the previous embodiments, the electronic device 600 further includes a signal input device 602. The signal input device 602 is coupled with the control circuit 601. Specifically, the control circuit 601 is configured to receive a control instruction input by the signal input device 602, and the control circuit 601 is configured to control a working state of the electrochromic module 100 according to the control instruction. The working state of the electrochromic module 100 includes controlling and changing voltages, or controlling and changing a state of a current signal to control the electrochromic module 100 to change color (a coloring or a discoloring state). The signal input device 602 may include a touch display screen 603 (also called a display module), an operation key 604, a trigger sensor 605, etc. The detailed structure and signal input mode are as follows.

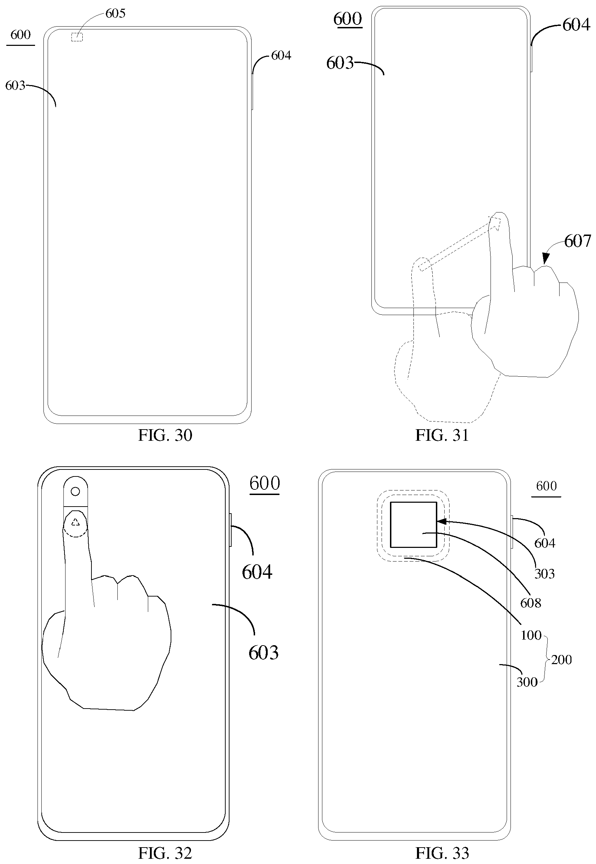

In some embodiments, as shown in FIG. 30, FIG. 30 illustrates a structural schematic view of the electronic device 600 according to an embodiment of the present disclosure. The signal input device 602 may be the touch display screen 603 (that is, a display module described in the above-mentioned embodiments). The control instruction input by the signal input device 602 may be a touch operation received by the touch display screen 603, and the control instruction includes at least one of sliding, clicking, and long-pressing. As shown in FIG. 31 and FIG. 32, FIG. 31 and FIG. 32 respectively illustrate schematic views of operation states of the electronic device according to some embodiments of the present disclosure. FIG. 31 may be indicated as an operator (the reference numeral 607 in FIG.31 may be indicated as the operator's hand) inputting the control instruction by sliding the touch display screen 603. A state shown in FIG. 32 may indicate that the operator inputs the control instruction by clicking or long-pressing a chart or a specific position of the touch display screen 603.

In an embodiment, as shown in FIG. 29, the signal input device 602 may be the operation key 604, and the control instruction may also be the trigger command of the operation key 604. The operation key 604 may be a separate key, or a key multiplexed with other functional keys of the electronic device 600, such as the power key, volume key, etc. Different control instructions received by the control circuit 601 are defined according to different key triggering modes, and thus the control circuit 601 may perform different signal controls of the electrochromic module 100.

In some embodiments, the control instruction is a use scenario that requires the electronic device 600 to change color. Specifically, the use scenario may include at least one of an image acquisition requirement, a flash activation requirement, and a color changing of automatic timing requirement, and other functional assemblies requirements. Specifically, the image acquisition requirement may be applied to the user's shooting needs, such as shooting, video recording, video call, unlocking needs of the electronic device 600, payment, encryption, answering calls, other confirmation needs, and other scenarios. The flash activation requirement may be a case that the user needs to turn on the flash light. Specifically, the control circuit 601 controls the electrochromic module 100 to change the transparent state, and may also be combined with the decorative unit 400 and other structures, such that the electronic device 600 may present the appearance of changing color.

Further, as shown in FIG. 29, the signal input device 602 may be a trigger sensor 605. The trigger sensor 605 may be a proximity sensor, the temperature sensor, an ambient light sensor, etc. The trigger sensor 605 collects peripheral signals of the electronic device 600 and controls the housing to change the appearance color via the control circuit 601. That is, the appearance color of the housing may be changed via the user to actively perform operational control, which is similar to the control mode by touching the display screen 603 and the operation key 604. In this embodiment, the appearance color of the housing may also be automatically controlled to change by means of triggering the sensor 605 automatically detecting an environmental signal.

The electronic device 600 provided according to the embodiments of the present disclosure has the appearance effect of color changing display, thereby presenting a very good and aesthetic appearance. In addition, the electronic device 600 may have an electrostatic prevention function.

In an embodiment, as shown in FIG. 33, FIG. 33 illustrates a structural schematic view of the electronic device according to another embodiment of the present disclosure. The electronic device 600 may also include a camera module 608. The camera module 608 is mounted on the imaging hole 303 of the cover plate 300, and the camera module 608 is configured for shooting. The camera module 608 may be exposed from the imaging hole 303 of the cover plate 300. The electrochromic module 100 has a ring structure and may be disposed around the imaging hole 303 of the cover plate 300. The electrochromic module 100 is used as a decorative member and matched with the camera module 608, such that the appearance expression of the cover plate 300 is improved, thereby preventing the appearance integrity of the electronic device 600 from being broken. In addition, the electrochromic module 100 used as the decorative member may play a matching role when the camera module 608 works.

In some scenarios, such as a photographing scenario, for the electrochromic module 100 with memory effect, when the camera module 608 is started, the electrochromic module 100 is immediately controlled by the control voltage to start coloring, the control voltage may be in a range from 0.6V to 2.0V, and the power is stopped until the electrochromic module 100 is completely colored. If the camera module 608 is turned off before or after coloring is finished, the electrochromic module 100 is immediately controlled by the control voltage and begins to discolor, the control voltage may be in a range from 0.6V to 2.0V, and the power is stopped until the electrochromic module 100 is completely discolored.

In some scenarios, such as a photographing scenario, for the electrochromic module 100 without memory effect, when the camera module 608 is started, the electrochromic module 100 is immediately controlled by the control voltage to start coloring, the control voltage may be in the range from 0.6V to 2.0V, and the power is on until the electrochromic module 100 is completely colored. If the camera module 608 is turned off, application of the control voltage is stopped or two poles of the electrochromic module 100 are short circuited, such that the electrochromic module 100 is discolored.

In some scenarios, for example, when the camera module 608 is in a long exposure mode, for the electrochromic module 100 with memory effect, the electrochromic module 100 is immediately controlled by the control voltage to start to color. After exposure, the electrochromic module 100 is immediately controlled by the control voltage and begins to discolor; the control voltage may be in the range from 0.6V to 2.0V. For the electrochromic module 100 without memory effect, the electrochromic module 100 is immediately controlled by the control voltage to start to color. After exposure, application of the control voltage is stopped or two poles of the electrochromic module 100 are short circuited, such that the electrochromic module 100 is discolored.

In the photographing scenario, the electrochromic module 100 may very clearly indicate the startup and shutdown of the camera module 608 at the time of photographing. In the long exposure mode, the electrochromic module 100 interacts with the exposure process. In this way, the fun and playability of the electronic device 600 may be increased, and the differentiation and competitiveness of products may be improved.

In several embodiments provided in the present disclosure, it can be understood that, the disclosed method and equipment may be realized by other means. For example, the device implementation mode described above is only schematic, for example, the division of modules or units is only a logical function division, and there may be another division mode in actual implementation, for example, a plurality of units or components may be combined or integrated into another system, or some features may be omitted or not implemented.

The units described as separate units can or cannot be physically separated, and the components as units displaying can or cannot be physical units, that is, they may be located in one place or distributed to a plurality of network units. Some or all of the units may be selected according to actual needs to achieve the purpose of the embodiment.

In addition, each functional unit in each embodiment of the present disclosure may be integrated in one processing unit, or each unit may exist physically independently, or two or more units may be integrated in one unit. The above-mentioned integrated units may be realized in the form of hardware or software functional units.

The above is only a part of embodiments of the present disclosure and is not intended to limit the scope of the present disclosure. Any equivalent structure or process transformation using the contents of the specification and the accompanying drawings of the present disclosure, or any direct or indirect application in other related technical fields, is equally included in the scope of the present disclosure.

## Claims

1. A cover plate assembly, comprising:
a transparent cover plate;
an electrochromic module, stacked on the transparent cover plate; wherein the electrochromic module comprises an encapsulation portion, a color-changing portion and a metal wire, the encapsulation portion encapsulates a peripheral side of the color-changing portion, and the metal wire is arranged in the encapsulation portion or arranged in the color-changing portion close to the encapsulation portion; and
a shielding layer, disposed between the transparent cover plate and the electrochromic module;
wherein the encapsulation portion and the metal wire are located within an orthographic projection region of the shielding layer on the electrochromic module.

2. The cover plate assembly according to claim 1, wherein a surface of the transparent cover plate at a side close to the electrochromic module is provided with a matte surface, and a haze of the matte surface is in a range from 65% to 85%.

3. The cover plate assembly according to claim 1, wherein the shielding layer is arranged on the transparent cover plate or the electrochromic module, and the shielding layer is a coating film or a colored ink layer.

4. The cover plate assembly according to claim 3, wherein the coating film is one of a mixed layer consisting of an indium layer, a silicon dioxide layer, and a titanium pentoxide layer, and a mixed layer consisting of a silicon dioxide layer and a niobium oxide layer.

5. The cover plate assembly according to claim 3, wherein the coating film is a gradient coating film, and the coating film gradually changes from middle of the coating film to an edge of the coating film, or gradually changes from an edge at one side of the coating film to an edge at an opposite side of the coating film.

6. The cover plate assembly according to any one of claims 1 to 5, wherein the shielding layer comprises a first light-shielding portion and a second light-shielding portion in an integrated structure, the first light-shielding portion is in an annular shape, the first light-shielding portion surrounds a periphery of the second light-shielding portion, the first light-shielding portion adjoins the second light-shielding portion, and a color presented by the second light-shielding portion is consistent with a color of the color-changing portion after coloring.

7. The cover plate assembly according to any one of claims 1 to 5, wherein the electrochromic module comprises a first substrate, a first conductive layer, a color-changing material layer, a second conductive layer, a second substrate, and an adhesive frame; the first substrate, the first conductive layer, the color-changing material layer, the second conductive layer and the second substrate are successively stacked, each of the first conductive layer and the second conductive layer is provided with the metal wire, and the adhesive frame is configured to encapsulate an outer side surface of the first conductive layer, the color-changing material layer, and the second conductive layer;
wherein a region where the adhesive frame is located is the encapsulation portion, and a region where the color-changing material layer is located is the color-changing portion.

8. The cover plate assembly according to claim 7, wherein the adhesive frame is disposed around a peripheral side of the first conductive layer, the color-changing material layer, the second conductive layer, and the second substrate, and the adhesive frame is adhered to a surface of the first substrate provided with the first conductive layer; or the adhesive frame is disposed around a peripheral side of the first substrate, the first conductive layer, the color-changing material layer, the second conductive layer, and the second substrate.

9. The cover plate assembly according to claim 8, wherein the electrochromic module further comprises a water and oxygen blocking unit, an area of the water and oxygen blocking unit is larger than that of the second substrate, and the water and oxygen blocking unit is adhered to a surface of the second substrate at a side away from the second conductive layer and to an end surface of the adhesive frame away from the first substrate.

10. The cover plate assembly according to claim 7, wherein the color-changing material layer is arranged corresponding to an overlapped area between an orthographic projection of the first conductive layer and an orthographic projection of the second conductive layer, and the metal wire is arranged corresponding to un-overlapped areas of the orthographic projection of the first conductive layer and the orthographic projection of the second conductive layer, respectively.

11. The cover plate assembly according to claim 10, wherein the electrochromic module further comprises a water and oxygen blocking unit, and the water and oxygen blocking unit is attached to a surface of the second substrate away from the second conductive layer.

12. The cover plate assembly according to claim 9 or 11, wherein the water and oxygen blocking unit comprises a third substrate, and a water and oxygen blocking layer coated on at least one surface of the third substrate.

13. The cover plate assembly according to claim 7, wherein the metal wire comprises a first metal wire and a second metal wire;
the first metal wire is connected with the first conductive layer, and the second metal wire is connected with the second conductive layer;
the first metal wire extends along a position close to an edge of a surface of the first conductive layer, and the second metal wire extends along a position close to an edge of a surface of the second conductive layer.

14. The cover plate assembly according to claim 13, wherein the electrochromic module further comprises a flexible circuit board (FPC), and the FPC is connected with the first metal wire and the second metal wire respectively.

15. The cover plate assembly according to claim 13, wherein the electrochromic module further comprises a flexible circuit board (FPC), the first substrate is further provided with a wiring connection end which is adjacent to and insulated from the first metal wire, the second metal wire is electrically connected with the wiring connection end of the first substrate, and the FPC is connected with the wiring connection end and the first metal wire respectively.

16. The cover plate assembly according to any one of claims 13 to 15, wherein an outer surface of each of the first metal wire and the second metal wire is provided with an insulation protection layer, and the insulation protection layer is configured to block the first metal wire and the second metal wire from the color-changing material layer.

17. An electronic device, comprising a display module, a middle frame, a main board, and a cover plate assembly, and the cover plate assembly comprising:
a transparent cover plate;
an electrochromic module, stacked on the transparent cover plate; wherein the electrochromic module comprises an encapsulation portion, a color-changing portion and a metal wire, the encapsulation portion encapsulates a peripheral side of the color-changing portion, and the metal wire is arranged in the encapsulation portion or arranged in the color-changing portion close to the encapsulation portion; and
a shielding layer, disposed between the transparent cover plate and the electrochromic module;
wherein the encapsulation portion and the metal wire are located within an orthographic projection region of the shielding layer on the electrochromic module;
wherein the display module and the cover plate assembly are respectively disposed on opposite sides of the middle frame and are fixedly connected with the middle frame, the electrochromic module is closer to the display module than the transparent cover plate, the main board is coupled with the electrochromic module, and the main board is configured to receive a control command to control the electrochromic module to change color.

18. The electronic device according to claim 17, wherein the control command is a touch operation received by the display module, and the touch operation comprises at least one of sliding, clicking, and long-pressing; or
the electronic device further comprises an operation key, and the control command is a trigger command of the operation key; or
the electronic device further comprises a trigger sensor, and the control command is a trigger command of the trigger sensor.

19. The electronic device according to claim 17 or 18, wherein the electronic device further comprises an appearance film layer, and the appearance film layer is disposed on a side of the electrochromic module away from the transparent cover plate.

20. The electronic device according to claim 17, wherein the electrochromic module comprises a first substrate, a first conductive layer, a color-changing material layer, a second conductive layer, a second substrate, and an adhesive frame; the first substrate, the first conductive layer, the color changing material layer, the second conductive layer, and the second substrate are successively stacked, each of the first conductive layer and the second conductive layer is provided with the metal wire, and the adhesive frame is configured to encapsulate an outer side of the first conductive layer, the color-changing material layer, and the second conductive layer; and
wherein a region where the adhesive frame is located is the encapsulation portion, and a region where the color-changing material layer is located is the color-changing portion.
